# EUROPÄISCHE PATENTSCHRIFT

(11) **EP 1 430 318 B1**
(45) Veröffentlichungstag und Bekanntmachung des Hinweises auf die Patenterteilung: **01.07.2009**
(21) Anmeldenummer: 02779120.1
(22) Anmeldetag: 21.09.2002
(51) Int. Cl.: G01R 31/08

(54) **VERFAHREN UND VORRICHTUNG ZUR LOKALISIERUNG EINES LEITUNGSFEHLERS**
METHOD AND DEVICE FOR LOCALIZING A LINE FAULT
PROCEDE ET DISPOSITIF DE LOCALISATION D'UNE ERREUR DANS UNE LIGNE

(30) Priorität: 21.09.2001 DE 10146859
(43) Veröffentlichungstag der Anmeldung: 23.06.2004
(73) Patentinhaber: Willtek Communications GmbH, 85737 Ismaning (DE)
(72) Erfinder: KLENNER, Günther, 83022 Rosenheim (DE)
(74) Vertreter: Verscht, Thomas Kurt Albert
(86) Internationale Anmeldenummer: PCT/DE2002/003578
(87) Internationale Veröffentlichungsnummer: WO 2003/027691

(56) Entgegenhaltungen:
- EP-A- 0 971 238
- US-A- 5 144 250
- US-A- 6 104 287

## Beschreibung

Die vorliegende Erfindung betrifft ein Verfahren zur Lokalisierung einer Störung in einer (Signal-)Leitung bzw. eines Leitungsfehlers. Ferner betrifft die Erfindung eine entsprechende Vorrichtung zur Durchführung des Verfahrens.

Im Stand der Technik sind zwei unterschiedliche Verfahren zum Bestimmen der Position eines Fehlers in einem Kabel (distance-to-fault, DTF-Messung) bekannt. Bei dem Impulsreflektionsmeßverfahren wird ein Puls in ein zu testendes Kommunikationskabel gesendet und alle reflektierten Wellen gemessen. Die gemessene Zeitverzögerung wird mit der Ausbreitungsgeschwindigkeit der Wellen in der Leitung multipliziert und die gesuchte Fehlerposition beträgt dann die Hälfte des gemessenen Ergebnisses. Dieses Verfahren wird hauptsächlich bei optischen Kabeln oder sehr langen Kabeln verwendet.

Für HF-Kabel oder kurze Kabel wird häufig das sogenannte inverse FFT-Konzept (FFT = Fast Fourier Transformation) verwendet. Ein variabler Frequenzgenerator sendet ein durchgestimmtes Signal in die Leitung. Ein Vektoranalysator mißt das Verhältnis von gesendetem und reflektiertem Signal im Pegel und in der Phase. Durch eine inverse FFT wird die Zeitverzögerung berechnet. Diese Zeitverzögerung multipliziert mit der halben Ausbreitungsgeschwindigkeit liefert dann die gesuchte Fehlerposition.

Die bekannten Verfahren sind insoweit nachteilig, daß die Leitung aufgrund der Messung blockiert ist und keine bestimmungsgemäße Datenübertragung stattfinden kann. Der Betrieb des Kabels muß daher zur Durchführung des Testbetriebs eingestellt werden. Das DTF-Meßgerät muß an das zu messende Kabel angeschlossen werden und zur Messung ist die Erzeugung und Einspeisung spezieller Testsignale erforderlich. Nach der Messung muß das Kabel erneut angeschlossen werden. Der Aufwand bei den bekannten Verfahren ist daher beträchtlich und ist insbesondere auch deshalb nicht zu vernachlässigen, da diese regelmäßig wiederholt werden müssen, um ein Kabel auf Verdacht im Hinblick auf einen Leitungsfehler zu untersuchen, um frühzeitig eine Störung erkennen zu können.

Zum Stand der Technik wird ferner auf die US-Patentschrift US-A-5,144,250 hingewiesen, aus welcher Leistungsverstärkerzeitraum-Reflektometer bekannt ist. Gemäß der Lehre dieser Druckschrift wird eine Systemkomponente in einer HF-Leistungsverstärkerausgangschaltung, welche ein Impedanzversagen aufweist, identifiziert. Ein HF-Signal wird auf einer Ausgangsleitung zu den zu testenden Systemkomponenten geleitet. Ein bidirektionaler Koppler detektiert die Wellenfront des Ausgang-EF-Signals und die Wellenfront des reflektierten HF-Signals, welches durch einen Impedanzfehler verursacht wird. Der Anfang der Ausgangsignalwellenfront wird verwendet, um eine Zeiststeuerungs- bzw. Timingeinrichtung auszulösen, welche die Zeitsteuerung bzw. das Timing durchführt bis der Anfang der reflektierten Signalwellenfront detektiert wird.

Aus der US-Patentschrift US-A-6,104,287 ist eine Vorrichtung zum Identifizieren einer beschädigten oder nicht-verbundenen HF-Last in einem HF-Kommunikationssystem bekannt. Dabei wird überwacht, ob ein Teil eines vorwärtigen HF-Signals, welches von einer HF-Quelle zu einer HF-Last gesandt wird, zu der HF-Quelle hin reflektiert wird. Die Vorrichtung weist eine Alarmschaltung auf, welche bestimmt, ob die reflektierte HF-Energie anzeigt, dass die HF-Last beschädigt oder nicht verbunden ist. Ferner weist die Vorrichtung eine Einrichtung zum Speisen von reflektierter HF-Energie an die Alarmschaltung auf.

Aus der europäischen Veröffentlichung EP 0 971 238 A2 ist ein Verfahren und eine Vorrichtung zur richtungsabhängigen Fehlerortung oder Nachrichtenübertragung auf Niederspannungsnetzen im Betriebszustand bekannt. Dabei wird eine Ankopplungseinrichtung in Form eines Richtkopplers verwendet.

Der Erfindung liegt daher die Aufgabe zugrunde, die Nachteile des Standes der Technik zu vermeiden, und insbesondere ein Verfahren der eingangs genannten Art derart weiterzubilden, daß auf einfache und zuverlässige Weise, insbesondere ohne aufwendige Modifikationen der Leitung zur Durchführung des Tests, ein Leitungsfehler und dessen Position bestimmt werden kann.

Die vorliegende Erfindung betrifft ein Verfahren zur Lokalisierung einer Störung in einer Leitung gemäß Patentanspruch 1. Ferner betrifft die vorliegende Erfindung eine Vorrichtung zur Lokalisierung einer Störung in einer Leitung gemäß Patentanspruch 12.

Bevorzugte Ausführungsbeispiele der vorliegenden Erfindung sind in den abhängigen Patentansprüchen offenbart.

Die vorliegende Erfindung ist grundsätzlich auf jede beliebige Leitung bzw. Kabel anwendbar, wobei die Leitung insbesondere eine HF-Leitung, eine elektrische Leitung oder ein Glasfaserkabel sein kann. Das erfindungsgemäße Verfahren nutzt den Verkehr auf der Leitung zu Test- bzw. Prüfzwecken aus, wobei die Erfindung unabhängig davon ist, ob der Leitungsverkehr uni- oder bidirektional ist. Bevorzugt ist allerdings ein unidirektionaler Leitungsverkehr, da hierdurch die Reflektion an der Störstelle besonders leicht als solche erkannt werden kann. Die Fehlerlokalisierung erfolgt zwar auch bei bidirektionalem Leitungsverkehr durch Ermittlung eines an der Störstelle reflektierten Anteils; dieser kann allerdings aufgrund seiner Korrelation zu dem auf die Störstelle einfallenden Signals von Verkehrssignalen gleicher Richtung unterschieden werden. Für die Erfindung wird nur jeweils ein (An-)Teil der sich in unterschiedlichen Richtungen ausbreitenden Signale benötigt, wobei der (An-)Teil insbesondere ein Intensitätsanteil ist, welcher die Signale bis auf die Intensitätsvenninderung unverändert lässt. Unter aus dem Betrieb der Leitung stammenden Signalen werden insbesondere alle Signale verstanden, die im Normalbetrieb, d.h. keinem gesonderten Testbetrieb, welcher spezielle Testsignale erforderlich macht, auftreten. Dies sind insbesondere die Nutzsignale, aber auch Steuersignale, Fülldaten und dergleichen.

Ein Vorteil der vorliegenden Erfindung besteht darin, daß diese hervorragend zur kontinuierlichen Überwachung einer Leitung geeignet ist. Das erfindungsgemäße Verfahren basiert auf der Überwachung der Leitungsverkehrs und macht keine gesonderten Testsignale erforderlich. Es setzt zwar einen Leitungsverkehr voraus, kann aber unabhängig von diesem, d.h. insbesondere ohne Beeinträchtigung desselben, den Testbetrieb durchführen. Durch den geringen messtechnischen Aufwand ist das erfindungsgemäße Verfahren zum Testen von Leitungen sozusagen "auf Verdacht" geeignet und liefert bereits die Position eines gegebenenfalls vorhandenen Fehlers, so daß unverzüglich und ohne weitergehende Ermittlungen Reparaturmaßnahmen eingeleitet werden können.

Vorteilhafterweise ist zur Aufnahme der Teile der ersten und zweiten Signale in der Leitung ein bidirektionaler Koppler vorgesehen. Dabei ist besonders bevorzugt, daß der bidirektionale Koppler in der Leitung im wesentlichen permanent installiert ist. Auf diese Weise ist es möglich, die zur Auswertung erforderlichen Signalteile aus der Leitung aufzunehmen, wobei der Übertragungsbetrieb nur minimal beeinträchtigt wird.

Zur Realisierung einer automatischen Überwachung ist bevorzugt, daß die Aufnahme der Signal(an)teile und/oder die Auswertung derselben zu vorgebbaren Zeitpunkten durchgeführt wird. Beispielsweise kann das erfindungsgemäße Verfahren in regelmäßigen Zeitabständen durchgeführt werden. Insbesondere eignet sich das erfindungsgemäße Verfahren zum Test auf Leitungsfehler, und zur darauffolgenden Bestimmung des Ortes desselben, auch wenn von vorneherein unklar ist, ob ein derartiger Fehler überhaupt vorliegt. Dies erleichtert die Wartung des bzw. der entsprechenden Kabelsystem(e), da Fehlerquellen frühzeitig detektiert werden können.

Zur einfachen Durchführung der Erfindung ist ferner bevorzugt, daß die Aufnahme der Signal(an)teile und/oder die Auswertung derselben ansprechend auf ein Femsteuerungssignal durchgeführt wird. Ein derartiges Signal kann von einer Bedienungsperson ausgelöst werden, ohne sich in der Nähe des zu untersuchenden Kabels aufhalten zu müssen, was insbesondere in Anwendungsfällen vorteilhaft ist, in welchen ein derartiger Aufenthalt gefährlich oder nicht einfach zu realisieren ist.

Um die Testergebnisse an eine Bedienungsperson zu übermitteln, ist bevorzugt, daß eine Übertragungseinrichtung vorgesehen ist, um die Ergebnisse der Auswertung an eine Überwachungseinheit zu übertragen. Die Überwachungseinheit kann dabei ein Kontrollzentrum oder auch eine portable von einer Wartungsperson mitgeführte Einheit sein. Dadurch, daß keine Bedienungsperson zur Durchführung des Leitungstests erforderlich ist, kann somit auf komfortable Weise insbesondere eine Dauerüberwachung realisiert werden.

Bevorzugt ist, daß zur Bestimmung der Position des Leitungsfehlers die aufgenommenen Signalteile korreliert werden. Dabei kann eine Kreuzkorrelation der ausgekoppelten Anteile des ersten und zweiten, sich entgegengesetzt ausbreitenden, Signals verwendet werden, um eine an der Störstelle reflektierten Anteil zu identifizieren und hieraus die Position des Fehlers bzw. den Abstand der Position des Leitungsfehlers zu der Aufnahme- bzw. Auskoppelstelle zu bestimmen. Ebenfalls können die beiden Anteile zusammen, d.h. ohne einen bidirektionalen Koppler, aufgenommen und die Auswertung durch eine Autokorrelation durchgeführt werden.

Insbesondere ist bevorzugt, daß die Korrelation insbesondere mehrfach durchgeführt wird, wobei bei einer hinreichend guten Korrelation des Teils des ersten Signals und des Teils des zweiten Signals zu einem vorgegebenen Zeitintervall die zeitliche Verzögerung des Teils des zweiten Signals zu dem Teil des ersten Signals erkannt und daraus die Position der Störung in der Leitung bestimmt wird. Auf diese Weise wird der Teil des zweiten Signals als ein an der Leitungsstörung zurückreflektierter Teil des ersten Signals erkannt bzw. "entlarvt" und somit kann aufgrund der Zeitverzögerung auf die Fehlerposition der Leitung geschlossen werden.

Vorteilhafterweise ist die Leitung ein HF-Kabel einer Basis- oder Feststation eines Mobilfunknetzes. Die in diesem Anwendungsfall auftretenden Signale (live traffic) sind zur Realisierung der vorliegenden Erfindung besonders geeignet. Ebenfalls ist diese Anwendung besonders bevorzugt, da für Wartungspersonal der Aufenthalt an einer Basisstation durch die hohen Feldstärken nicht ungefährlich ist, und durch die Erfindung das Erfordernis des Anschlusses von speziellen Testgeräten entfällt. Wie oben erläutert wurde kann das erfindungsgemäße Verfahren nämlich ohne die Anwesenheit von Bedienungspersonal, z.B. per Fernsteuerung oder zu festen Zeitpunkten automatisch, durchgeführt werden.

Die aus der Leitung ausgekoppelten zwei Signalteile werden erfindungsgemäß zur Auswertung an einen Ein-Weg-Empfänger gespeist, wobei ein Umschalter zur jeweiligen Einspeisung eines Signalteils vorgesehen ist, wobei in einem der zwei Signalpfade zwischen dem bidirektionalen Koppler und dem Ein-Weg-Empfänger eine Verzögerungskomponente vorgesehen ist, und wobei in einer Betriebsphase durch den Umschalter dem Ein-Weg-Empfänger ein Signalteil eingespeist wird, während der andere Signalteil durch die Verzögerungskomponente verzögert wird. Durch eine entsprechende Ablaufsteuerung des Umschalters und des Verzögerungsgliedes gelingt es, beide Signalteile zeitlich nacheinander mit nur einer Messeinrichtung aufzunehmen und anschließend auszuwerten.

Vorteilhafterweise bildet die Leitung einen Teil eines Netzwerkes. In diesem Anwendungsfall sind nämlich die herkömmlichen Verfahren, insbesondere das eingangs erwähnte Impulsreflektionsmeßverfahren aufgrund der Bandpaßcharakteristiken des Netzwerks nicht besonders geeignet.

Vorteilhafterweise werden die Signale, insbesondere vor der Auswertung, dahingehend untersucht bzw. bewertet, ob und inwieweit diese zur Auswertung geeignet sind. Da zur Realisierung der Erfindung im Normalbetrieb auf der Leitung auftretende Verkehrssignale herangezogen werden, werden unterschiedliche Signaltypen zur Auswertung herangezogen. Manche sind zur Auswertung besser und andere schlechter geeignet. Bei manchen kann das erfindungsgemäße Verfahren zwar durchgeführt, aber die Fehlerposition nicht besonders genau ermittelt werden. Insbesondere in diesem Fall ist eine wiederholte bzw. mehrfache Anwendung des erfindungsgemäßen Verfahrens bevorzugt, um die Messgenauigkeit der Fehlerposition zu erhöhen. Bevorzugt weist daher die Auswerteeinheit Mittel auf, um das Signal auf dessen Eignung für das erfindungsgemäße Verfahren zu untersuchen. Beispielsweise können dazu typische auf der Leitung auftretende und zur Durchführung der Erfindung besonders geeignete Signalverläufe vorgespeichert sein, mit welchen der laufende Signalverkehr verglichen wird. Falls ein derartiges Signal auftritt, liefert das vorliegende Verfahren mit hoher Genauigkeit ein zufriedenstellendes Ergebnis. Ebenso können auf diese Weise Signale von der erfindungsgemäßen Auswertung ausgeschlossen werden.

Weitere bevorzugte Ausführungsformen der Erfindung sind in den abhängigen Patentansprüchen offenbart.

Die Erfindung, sowie weitere Merkmale, Ziele, Vorteile und Anwendungsmöglichkeiten derselben, wird bzw. werden nachfolgend anhand einer Beschreibung von bevorzugten Ausführungsbeispielen unter Bezugnahme auf die beigefügten Zeichnungen näher erläutert. In den Zeichnungen bezeichnen dieselben Bezugszeichen dieselben bzw. entsprechende Elemente. Dabei bilden alle beschriebenen und/oder bildlich dargestellten Merkmale für sich oder in beliebiger sinnvoller Kombination den Gegenstand der vorliegenden Erfindung, und zwar unabhängig von ihrer Zusammenfassung in den Patentansprüchen oder deren Rückbeziehung. In den Zeichnungen zeigen:
- Fig. 1: eine schematische Darstellung zur Erläuterung des Fehlerverhaltens in einer Lei- tung;
- Fig. 2: eine schematische Darstellung eines Beispiels unter Verwendung eines zwei Weg-Empfängers; und
- Fig. 3: eine schematische Darstellung eines zweiten Ausführungsbeispiels der vorlie- genden Erfindung unter Verwendung eines Ein-Wege-Empfängers.

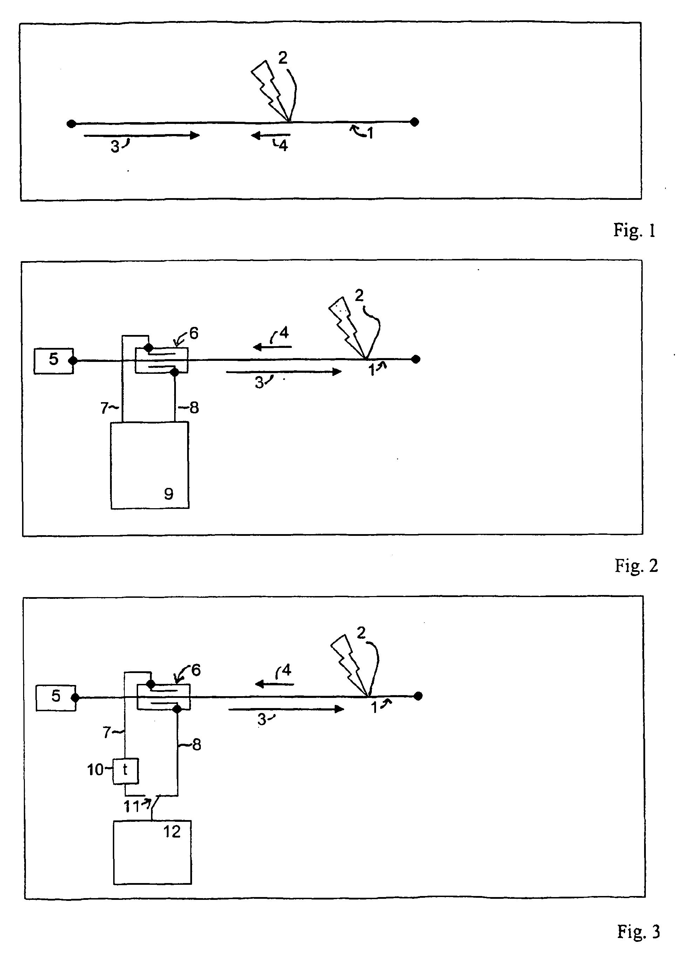

In Fig. 1 ist schematisch der Ausgangspunkt der vorliegenden Erfindung, und ganz allgemein einer DTF-Messung, schematisch dargestellt. In einer Leitung 1, welche vorzugsweise einer Kommunikationsverbindung dient, befindet sich an einer mit 2 bezeichneten Stelle ein durch einen stilisierten Blitz angezeigte Störung bzw. Fehler bzw. Defekt. Die Störung kann dabei beispielsweise ein (teilweiser) Kabelbruch sein. Die Leitung 1 kann irgendeinem uni- oder bidirektionalem kabelgebundenen Datenaustausch dienen, und kann insbesondere ein Kabel zur Übertragung von elektrischen Signalen und/oder eine Glasfaser zur Übertragung von optischen Signalen sein. Eine bevorzugte Anwendung der vorliegenden Erfindung sind HF-Kabel wie sie in Basis- oder Feststationen von Mobilfunksystemen eingesetzt werden. Diese Störung an der Stelle 2 bewirkt nun, daß ein sich von links nach rechts in der Leitung 1 ausbreitendes Signal 3 zumindest teilweise zu seinem Ursprung zurückreflektiert wird. Das reflektierte Signal 4 ist dabei im allgemeinen in seiner Intensität kleiner als das Signal 3, was durch den Pfeil kleinerer Länge in der Fig. 1 schematisch angezeigt ist. Eine derartige Störung beeinträchtigt daher die Kommunikation auf der Leitung 1 und muß repariert werden. Hierzu ist insbesondere erforderlich, gerade bei langen Leitungen, die Stelle 2 der Störung mit einer ausreichenden Genauigkeit zu lokalisieren.

Gemäß eines Beispiels, schematisch dargestellt in Fig. 2, ist in der Leitung 1 ein bidirektionaler Koppler 6, vorzugsweise permanent, eingebaut. Ein von einem Datensender 5 ausgesandtes Signal 3 wird durch den Fehler an der Stelle 2 reflektiert, wodurch ein sich entgegengesetzt in der Leitung ausbreitendes Signal 4 erzeugt wird. Der bidirektionale Koppler 6 koppelt nun einen Teil des Sendesignals 3 und des reflektierten Signals 4 aus der Leitung 1 aus, ohne im allgemeinen den Betrieb auf der Leitung 1 zu beeinträchtigen. Ein Zwei-Wege-Empfänger 9 mißt und speichert die ausgekoppelten Anteile 7 und 8 der Signale 4 bzw. 3. Die Anteile 7 und 8 werden miteinander verglichen, wozu insbesondere eine (Kreuz-) Korrelation verwendet wird. Aus der Korrelation kann die Verzögerung des reflektierten Anteils 7 gegenüber dem Anteil 8 bestimmt, und daraus auf die Fehlerposition 2 geschlossen werden. Bei der Korrelation wird insbesondere nach charakteristischen Merkmalen bzw. einem "Fingerprint" des ausgesandten Signals in dem zurückreflektierten Signals gesucht. Dies wird insbesondere mehrfach in verschiedenen Zeitabständen, insbesondere zeitversetzt, durchgeführt. Eine hinreichend gute Korrelation wird erkannt und daraus auf die Zeitverzögerung geschlossen, bei der die hinreichend gute Korrelation auftrat. Aus der Ausbreitungsgeschwindigkeit des Signals kann dann aus der Zeitverzögerung direkt auf den Ort bzw. die Position des Defekts geschlossen werden.

Ein Ausführungsbeispiel der vorliegenden Erfindung ist schematisch in Fig. 3 dargestellt. Im Unterschied zu dem oben in Verbindung mit Fig. 2 beschriebenen Ausführungsbeispiel wird hier anstelle des Zwei-Wege-Empfängers 9 ein Ein-Weg-Empfänger 12 verwendet. Um beide Anteile 7 und 8 mit dem Ein-Weg-Empfänger aufzunehmen ist ein Verzögerungsbauteil 10 in einem Signalpfad zwischen dem Koppler 6 und dem Ein-Weg-Empfänger 12 vorgesehen. Das Verzögerungsbauteil 10 ist im Aus-Rihrungsbeispiel in dem Pfad eingebaut, welcher den Anteil 7 des am Defekt 2 reflektierten Signals 4 vom Koppler 6 an dem Empfänger 12 überträgt. Die Verzögerung des Verzögerungsbauteils 10 ist vorzugsweise einstellbar. Ein (Um-)Schalter 11 ist am Eingang des Ein-Weg-Empfängers 12 vorgesehen, um zwischen den zwei vom bidirektionalen Koppler 6 gelieferten Signalen umzuschalten. Während ein Pfad durch den Ein-Weg-Empfänger 12 gemessen und gespeichert wird, wird der andere Pfad verzögert. Dann wird der Schalter umgeschaltet und das verzögerte Signal wird ebenfalls gemessen. Die beiden aufgezeichneten Signale werden wie zuvor erläutert mit einer (Kreuz-) Korrelation ausgewertet, um die Stelle 2 der Störung zu lokalisieren.

Die Erfindung wurde vorstehend anhand von bevorzugten Ausfiihrungsformen derselben näher erläutert. Für einen Fachmann ist es jedoch offensichtlich, daß unterschiedliche Abwandlungen und Modifikationen gemacht werden können, ohne von dem der Erfindung zugrundeliegenden Gedanken abzuweichen.

## Patentansprüche

1. Verfahren zur Lokalisierung einer Störung in einer Leitung (1), wobei wenigstens ein Teil eines, aus dem Betrieb der Leitung (1) stammenden, in einer Ausbreitungsrichtung propagierenden ersten Signals und wenigstens ein Teil eines in der anderen Ausbreitungsrichtung propagierenden zweiten Signal aufgenommen und zur Bestimmung der Position (2) der Störung in der Leitung (1) ausgewertet werden, und wobei
zur Aufnahme der Teile der ersten und zweiten Signale in der Leitung (1) ein bidirektionaler Koppler (6) vorgesehen ist,
**dadurch gekennzeichnet, daß** die aus der Leitung (I) ausgekoppelten zwei Signalteile zur Auswertung an einen Ein-Weg-Empfanger (12) gespeist werden, wobei ein Umschalter (11) zur jeweiligen Einspeisung eines Signalteils vorgesehen ist, wobei in einem der zwei Signalpfade zwischen dem bidirektionalen Koppler (6) und dem Ein-Weg-Empfänger (12) eine Verzogerongskomponente (10) vorgesehen ist, und wobei in einer Betriebsphase durch den Umschalter (11) dem Ein-Weg-Empfänger (12) ein Signalteil eingespeist wird, während der andere Signalteil durch die Verzögerungskomponente (10) verzögert wird.

2. Verfahren nach Anspruch 1 **dadurch gekennzeichnet, daß** der bidirektionale Koppler (6) in der Leitung (1) im wesentlichen permanent installiert ist.

3. Verfahren nach Anspruch 1 oder 2, **dadurch gekennzeichnet daß** die Aufnahme der Signalteile und/oder die Auswertung derselben zu vorgebbaren Zeitpunkten durchgeführt wird.

4. Verfahren nach Anspruch 1 oder 2, **dadurch gekennzeichnet, daß** die Aufnahme der Signalteile und/oder die Auswertung derselben ansprechend auf ein Fernsteuerungssignal durchgeführt wird.

5. Verfahren nach einem der Ansprüche 1 bis 4, **dadurch gekennzeichnet, daß** eine Übertragungseinrichtung vorgesehen ist, um die Ergebnisse der Auswertung an eine Überwachungseinheit zu übertragen.

6. Verfahren nach einem der Ansprüche 1 bis 5, **dadurch gekennzeichnet daß** zur Bestimmung der Position (2) der Störung in der Leitung (1) die aufgenommenen Signalteile korreliert werden.

7. Verfahren nach Anspruch 6, **dadurch gekennzeichnet, daß** die Korrelation insbesondere mehrfach durchgeführt wird, wobei bei einer hinreichend guten Korrelation des Teils des ersten Signals und des Teils des zweiten Signals zu einem vorgegebenen Zeitintervall die zeitliche Verzögerung des Teils des zweiten Signals zu dem Teil des ersten Signals erkannt und daraus die Position der Störung in der Leitung (1) bestimmt wird.

8. Verfahren nach einem der Ansprüche 1 bis 7, **dadurch gekennzeichnet, daß** die Leitung (1) eine HF-Leitung, eine elektrische Leitung oder ein Glasfaserkabel ist.

9. Verfahren nach Anspruch 8, **dadurch gekennzeichnet,daß** die Leitung (1) ein HF-Kabel einer Basis- oder Feststation eines Mobilfunknetzes ist.

10. Verfahren nach einem der Ansprüche 1 bis 9, **dadurch gekennzeichnet, daß** die Leitung (1) einen Teil eines Netzwerkes bildet.

11. Verfahren nach einem der Ansprüche 1 bis 10, **dadurch gekennzeichnet,daß** die Signale, insbesondere vor der Auswertung, dahingehend untersucht werden, ob diese zur Auswertung geeignet sind.

12. Vorrichtung zur Lokalisierung einer Störung in einer Leitung (1), wobei die Vorrichtung folgendes aufweist:
- eine Aufnahmeeinrichtung, um wenigstens einen Teil (6,7) eines, aus dem Betrieb der Leitung (1) stammendes, in einer Ausbreitungsrichtung propagierenden ersten Signals und wenigstens einen Teil eines in der anderen Ausbreitungsrichtung propagierenden zweiten Signals aufzunehmen; und
- eine Auswerteeinrichtung zur Bestimmung der Position (2) der Störung in der Leitung (1), wobei
die Aufnahmeeinrichtung ein bidirektionaler Koppler (6) ist,
**dadurch gekennzeichnet, daß** die aus der Leitung (1) ausgekoppelten zwei Signalteile zur Auswertung an einen Ein-Weg-Empfänger (12) gespeist werden, wobei ein Umschalter (11) zur jeweiligen Einspeisung eines Signalteils vorgesehen ist, wobei in einem der zwei Signalpfade zwischein dem bidirektionalen Koppler (6) und dem Ein-Weg-Empfänger (12) eine Verzögerungskomponente (10) vorgesehen ist, und wobei in einer Betriebsphase durch den Umschalter (11) dem Ein-Weg-Empfänger (12) ein Signalteil eingespeist wird, während der andere Signalteil durch die Verzögerungskomponente (10) verzögert wird.

13. Vorrichtung nach Anspruch 12, **dadurch gekennzeichnet daß** der bidirektionale Koppler (6) in der Leitung (1) im wesentlichen permanent installiert ist.

14. Vorrichtung nach Anspruch 12 order 13, **gekennzeichnet durch** Mittel zur Aufnahme der Signalteile und/oder zur Auswertung derselben zu vorgebbaren Zeitpunkten.

15. Vorrichtung nach Ansprüche 12 order 13, **gekennzeichnet durch** Mittel zur Aufnahme der Signalteile und/oder zur Auswertung derselben ansprechend auf ein Femsteuerungssignal.

16. Vorrichtung nach einem der Ansprüche 12 bis 15, **dadurch gekennzeichnet, daß** die Vorrichtung ferner eine Übertragungseinrichtung aufweist, um die Ergebnisse der Auswertung an eine Überwachungseinheit zu übertragen.

17. Vorrichtung nach einem der Ansprüche 12 bis 16, **dadurch gekennzeichnet, daß** zur,Bestimmung der Position (2) der Störung in der Leitung (1) die Vorrichtung Mittel aufweist, um die aufgenommenem Signalteile in der Auswerteeirichtung zu korrelieren.

18. Vorrichtung nach Anspruch 17, **dadurch gekennzeichnet, daß** die Mittel die Korrelation insbesondere mehrfach durchgeführen, wobei bei einer hinreichend guten Korrelation des Teils des ersten Signals und des Teils des zweiten Signals zu einem vorgegebenen Zeitintervall die zeitliche Verzögerung des Teils des zweiten Signals zu dem Teil des ersten Signals erkannt und daraus die Position der Störung in der Leitung (1) bestimmt wird.

19. Vorrichtung nach einem der Ansprüche 12 bis 18, **dadurch gekennzeichnet, daß** die Leitung (1) eine HF-Leitung, eine elektrische Leitung oder ein Glasfaserkabel ist

20. Vorrichtung nach Anspruch 19, **dadurch gekennzeichnet, daß** die Leitung (1) ein HF-Kabel einer Basis- oder Feststation eines Mobilfunknetzes ist.

21. Vorrichtung nach einem der Ansprüche 12 bis 20, **dadurch gekennzeichnet daß** die Leitung (1) einen Teil eines Netzwerkes bildet.

22. Vorrichtung nach einem der Ansprüche 12 bis 21, **dadurch gekennzeichnet,daß** die Signale, insbesondere vor der Auswertung, dahingehend untersucht werden, ob diese zur Auswertung geeignet sind.

## Claims

1. Method for localizing a fault in a line (1), wherein at least a part of a first signal originating from the operation of the line (1) and propagating in one direction of propagation and at least a part of a second signal propagating in the other direction of propagation are recorded and evaluated for determining the position (2) of the fault in the line (1), and wherein a bidirectional coupler (6) is provided for recording the parts of the first and second signals in the line (1), **characterized in that** the two signal parts coupled out of the line (1) are fed to a one-way receiver (12) for the evaluation, wherein a change-over switch (11) is provided for the respective feeding-in of a signal part, wherein a delay component (10) is provided in one of the two signal paths between the bidirectional coupler (6) and the one-way receiver (12), and wherein one signal part is fed into the one-way receiver (12) by the change-over switch (11) in one operating phase whilst the other signal part is delayed by the delay component (10).

2. Method according to Claim 1, **characterized in that** the bidirectional coupler (6) is essentially permanently installed in the line (1).

3. Method according to Claim 1 or 2, **characterized in that** the recording of the signal parts and/or the evaluation thereof is carried out at predeterminable times.

4. Method according to Claim 1 or 2, **characterized in that** the recording of the signal parts and/or the evaluation thereof is carried out in response to a remote control signal.

5. Method according to one of Claims 1 to 4, **characterized in that** a transmission device is provided in order to transmit the results of the evaluation to a monitoring unit.

6. Method according to one of Claims 1 to 5, **characterized in that**, in order to determine the position (2) of the fault in the line (1), the recorded signal parts are correlated.

7. Method according to Claim 6, **characterized in that** the correlation, in particular, is carried out several times, wherein, in the case of a sufficiently good correlation of the part of the first signal and of the part of the second signal to a predetermined time interval, the time delay of the part of the second signal with respect to the part of the first signal is detected and from this the position of the fault in the line (1) is determined.

8. Method according to one of Claims 1 to 7, **characterized in that** the line (1) is an RF line, an electric line or a glass fibre cable.

9. Method according to Claim 8, **characterized in that** the line (1) is an RF cable of a base station or fixed station of a mobile radio network.

10. Method according to one of Claims 1 to 9, **characterized in that** the line (1) forms a part of a network.

11. Method according to one of Claims 1 to 10, **characterized in that** the signals are examined, especially before the evaluation, as to whether they are suitable for the evaluation.

12. Device for localizing a fault in a line (1), wherein the device exhibits the following:
- a recording device in order to record at least a part (6, 7) of a first signal originating from the operation of the line (1) and propagating in one direction of propagation and at least a part of a second signal propagating in the other direction of propagation; and
- an evaluating device for determining the position (2) of the fault in the line (1), wherein the recording device is a bidirectional coupler (6),
**characterized in that** the two signal parts coupled out of the line (1) are fed to a one-way receiver (12) for the evaluation, wherein a change-over switch (11) for respectively feeding-in a signal part is provided, wherein a delay component (10) is provided in one of the two signal paths between the bidirectional coupler (6) and the one-way receiver (12), and wherein a signal part is fed into the one-way receiver (12) by the change-over switch (11) in one operating phase whilst the other signal part is delayed by the delay component (10).

13. Device according to Claim 12, **characterized in that** the bidirectional coupler (6) is essentially permanently installed in the line (1).

14. Device according to Claim 12 or 13, **characterized by** means for recording the signal parts and/or for evaluating them at predeterminable times.

15. Device according to Claim 12 or 13, **characterized by** means for recording the signal parts and/or for evaluating them in response to a remote control signal.

16. Device according to one of Claims 12 to 15, **characterized in that** the device also exhibits a transmission device in order to transmit the results of the evaluation to a monitoring unit.

17. Device according to one of Claims 12 to 16, **characterized in that**, in order to determine the position (2) of the fault in the line (1), the device exhibits means for correlating the recorded signal parts in the evaluating device.

18. Device according to Claim 17, **characterized in that** the means, in particular, carry out the correlation several times, wherein in the case of a sufficiently good correlation of the part of the first signal and of the part of the second signal with respect to a predetermined time interval, the time delay of the part of the second signal with respect to the part of the first signal is detected and from this the position of the fault in the line (1) is determined.

19. Device according to one of Claims 12 to 18, **characterized in that** the line (1) is an RF line, an electrical line or a glass fibre cable.

20. Device according to Claim 19, **characterized in that** the line (1) is an RF cable of a base station or a fixed station of a mobile radio network.

21. Device according to one of Claims 12 to 20, **characterized in that** the line (1) forms a part of a network.

22. Device according to one of Claims 12 to 21, **characterized in that** the signals are examined, particularly before the evaluation, as to whether they are suitable for evaluation.

## Revendications

1. Procédé pour localiser un défaut dans une ligne (1), selon lequel une partie au moins d'un premier signal qui provient du fonctionnement de la ligne (1) et qui se propage dans un sens de propagation et une partie au moins d'un second signal qui se propage dans l'autre sens de propagation sont enregistrées et sont analysées pour définir la position (2) du défaut dans la ligne (1), et il est prévu pour enregistrer les parties des premier et second signaux dans la ligne (1) un coupleur bidirectionnel (6),
**caractérisé en ce que** les deux parties de signaux captées à partir de la ligne (1) sont transmises, en vue d'une analyse, à un récepteur à une voie (12), un commutateur (11) étant prévu pour transmettre à chaque fois une partie de signal, étant précisé qu'il est prévu dans l'une des deux trajectoires de signaux, entre le coupleur bidirectionnel (6) et le récepteur à une voie (12), un composant de retard (10), et que dans une phase de fonctionnement le commutateur (11) transmet une partie de signal au récepteur à une voie (12) tandis que l'autre partie de signal est retardée par le composant (10).

2. Procédé selon la revendication 1, **caractérisé en ce que** le coupleur bidirectionnel (6) prévu dans la ligne (1) est installé de manière globalement permanente.

3. Procédé selon la revendication 1 ou 2, **caractérisé en ce que** l'enregistrement des parties de signaux et/ou l'analyse de celles-ci sont effectuées à des moments aptes à être prédéfinis.

4. Procédé selon la revendication 1 ou 2, **caractérisé en ce que** l'enregistrement des parties de signaux et/ou l'analyse de celles-ci sont effectuées en réponse à un signal de commande à distance.

5. Procédé selon l'une des revendications 1 à 4, **caractérisé en ce qu'**il est prévu un dispositif de transmission pour transmettre les résultats de l'analyse à une unité de contrôle.

6. Procédé selon l'une des revendications 1 à 5, **caractérisé en ce que** pour définir la position (2) du défaut dans la ligne (1), les parties de signaux enregistrées sont corrélées.

7. Procédé selon la revendication 6, **caractérisé en ce que** la corrélation est effectuée en particulier plusieurs fois, étant précisé que dans le cas d'une corrélation suffisamment bonne de la partie du premier signal et de la partie du second signal suivant un intervalle de temps prédéfini, le retard de la partie du second signal par rapport à la partie du premier signal est détecté et la position du défaut dans la ligne (1) est définie à partir de ce retard.

8. Procédé selon l'une des revendications 1 à 7, **caractérisé en ce que** la ligne (1) est constituée par une ligne haute fréquence, une ligne électrique ou un câble à fibres de verre.

9. Procédé selon la revendication 8, **caractérisé en ce que** la ligne (1) est constituée par un câble haute fréquence d'une station de base ou d'une station fixe d'un réseau de téléphonie mobile.

10. Procédé selon l'une des revendications 1 à 9, **caractérisé en ce que** la ligne (1) forme une partie d'un réseau.

11. Procédé selon l'une des revendications 1 à 10, **caractérisé en ce que** les signaux, en particulier avant l'analyse, font l'objet d'un examen pour voir s'ils sont aptes à être analysés.

12. Dispositif pour localiser un défaut dans une ligne (1), ce dispositif comportant :
- un dispositif d'enregistrement pour enregistrer une partie (6, 7) au moins d'un premier signal qui provient du fonctionnement de la ligne (1) et qui se propage dans un sens de propagation et une partie au moins d'un second signal qui se propage dans l'autre sens de propagation ;et
- un dispositif d'analyse pour définir la position (2) du défaut dans la ligne (1),
le dispositif d'enregistrement étant constitué par un coupleur bidirectionnel (6),
**caractérisé en ce que** les deux parties de signaux captées à partir de la ligne (1) sont transmises, en vue d'une analyse, à un récepteur à une voie (12), un commutateur (11) étant prévu pour transmettre à chaque fois une partie de signal, étant précisé qu'il est prévu dans l'une des deux trajectoires de signaux, entre le coupleur bidirectionnel (6) et le récepteur à une voie (12), un composant de retard (10), et que dans une phase de fonctionnement le commutateur (11) transmet une partie de signal au récepteur à une voie (12) tandis que l'autre partie de signal est retardée par le composant (10).

13. Dispositif selon la revendication 12, **caractérisé en ce que** le coupleur bidirectionnel (6) prévu dans la ligne (1) est installé de manière globalement permanente.

14. Dispositif selon la revendication 12 ou 13, **caractérisé par** des moyens pour enregistrer les parties de signaux et/ou pour analyser celles-ci à des moments aptes à être prédéfinis.

15. Dispositif selon la revendication 12 ou 13, **caractérisé par** des moyens pour enregistrer les parties de signaux et/ou pour analyser celles-ci en réponse à un signal de commande à distance.

16. Dispositif selon l'une des revendications 12 à 15, **caractérisé en ce que** le dispositif comporte par ailleurs un dispositif de transmission pour transmettre les résultats de l'analyse à une unité de contrôle.

17. Dispositif selon l'une des revendications 12 à 16, **caractérisé en ce que** pour définir la position (2) du défaut dans la ligne (1), le dispositif comporte des moyens pour corréler dans le dispositif d'analyse les parties de signaux enregistrées.

18. Dispositif selon la revendication 17, **caractérisé en ce que** les moyens effectuent la corrélation en particulier plusieurs fois, étant précisé que dans le cas d'une corrélation suffisamment bonne de la partie du premier signal et de la partie du second signal suivant un intervalle de temps prédéfini, le retard de la partie du second signal par rapport à la partie du premier signal est détecté et la position du défaut dans la ligne (1) est définie à partir de ce retard.

19. Dispositif selon l'une des revendications 12 à 18, **caractérisé en ce que** la ligne (1) est constituée par une ligne haute fréquence, une ligne électrique ou un câble à fibres de verre.

20. Dispositif selon la revendication 19, **caractérisé en ce que** la ligne (1) est constituée par un câble haute fréquence d'une station de base ou d'une station fixe d'un réseau de téléphonie mobile.

21. Dispositif selon l'une des revendications 12 à 20, **caractérisé en ce que** la ligne (1) forme une partie d'un réseau.

22. Dispositif selon l'une des revendications 12 à 21, **caractérisé en ce que** les signaux, en particulier avant l'analyse, font l'objet d'un examen pour voir s'ils sont aptes à être analysés.
